(19) Europäisches Patentamt
European Patent Office
Office européen des brevets

(11) EP 2 067 873 A1

(12) EUROPEAN PATENT APPLICATION

(43) Date of publication:
10.06.2009 Bulletin 2009/24

(51) Int Cl.:
C23C 14/34 (2006.01)    C23C 14/14 (2006.01)

(21) Application number: 08018005.2

(22) Date of filing: 14.10.2008

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: 29.11.2007 JP 2007309248

(71) Applicant: **Kobelco Research Institute , Inc.**
**Kobe-shi**
**Hyogo 651-0073 (JP)**

(72) Inventor: **Matsuzaki, Hitoshi**
**Takasago-shi,**
**HYOGO 676-8670 (JP)**

(74) Representative: **Müller-Boré & Partner**
**Patentanwälte**
**Grafinger Strasse 2**
**81671 München (DE)**

(54) **Ag-based sputtering target**

(57) Disclosed is an Ag-based sputtering target composed of pure Ag or Ag alloy wherein when the average grain size $d_{ave}$ of the sputtering face of the Ag-based sputtering target is measured in accordance with the procedures 1-3 described below, the average grain size $d_{ave}$ satisfies 10 $\mu$m or less.
(Procedure 1) In the surface of the sputtering face, a plurality of locations are optionally selected, and a micrograph (magnification: 40-2,000 times) of each selected location is taken.
(Procedure 2) Four or more straight lines are drawn in a grid pattern or radially on each micrograph, a number n of grain boundaries existing on the straight line is investigated, and a grain size d is calculated on the basis of the following equation on each straight line.

$$d = L/n/m$$

where, L represents the length of the straight line, n represents the number of the grain boundaries existing on the straight line, and m represents the magnification of the micrograph.
(Procedure 3) The average value of the grain sizes d of all selected locations is made the average grain size $d_{ave}$ of the sputtering face.

FIG. 4

**Description**

BACKGROUND OF THE INVENTION

1. Field of the Invention

The present invention relates to an Ag-based sputtering target useful for forming an Ag-based thin film by a sputtering method and an Ag-based thin film obtainable using the Ag-based sputtering target, more specifically relates to an Ag-based sputtering target capable of forming an Ag-based thin film extremely excellent in in-plane uniformity.

2. Description of the Related Art

The Ag-based thin film of pure Ag or Ag alloy and the like is excellent in optical properties such as high reflectance and transmittance and a low extinction coefficient, excellent in thermal properties with high thermal conductivity, and excellent in electrical properties with low electrical resistivity, and has excellent surface smoothness. Therefore, the Ag-based thin film is widely applied, for example, to; a reflective film, a semi-transparent reflective film, and a thermal diffusion film for an optical information record medium (optical disk); a reflective film, a reflective electrode film, and a wiring film for a flat panel display; a low-E (low emissivity) film for a heat ray reflective/cutoff window glass and the like; a shield film for an electromagnetic wave shield; a reflective film for an automobile head lamp and a lighting apparatus; a reflective film and a reflective electrode film for an optical part and a light emission diode; and the like. In particular, the Ag-based thin film has fully high reflectance for a blue-violet laser as well used for a next-generation optical disk and also has high thermal conductivity required for a write once/rewritable optical disk, therefore it is suitably used for these applications as well.

The Ag-based thin film is preferably formed by a sputtering method wherein a sputtering target composed of pure Ag or Ag alloy (Ag-based sputtering target) is subjected to sputtering. The sputtering method is a method wherein a plasma discharge is formed between a substrate and a sputtering target (hereafter, may be referred to as target) within a sputtering chamber to which Ar is introduced after evacuation, the Ar ionized by the plasma discharge is made collided with the target, the target atoms are beaten out and deposited on the substrate, thereby the thin film is formed. The thin film formed by the sputtering method is superior in in-plane uniformity such as the componential composition and a film thickness in the film plane direction (within the film face) compared with the thin film formed by an ion plating method, a vacuum depositing method, and an electron beam depositing method. In addition, the sputtering method has a merit of ability to form a thin film with the same componential composition with that of the target, which is different with the vacuum depositing method.

So that such high quality thin film can be formed, crystal grains of the target are required to be uniformly refined as much as possible in the sputtering face direction (within the sputtering face). The reason is that, in a thin film obtained using a target in the sputtering face of which coarse crystal grains exist, variation in the componential composition, the film thickness and the like within the film face becomes large, which causes variation in properties of reflectance and the like, and the properties as a reflective film and the like extremely deteriorate.

As the techniques for refining crystal grains of a target, Ag-based sputtering targets exhibited in the patent document 1 to the patent document 5 can be exemplarily cited. All of these Ag-based sputtering targets are manufactured by a melting and casting method. Also, according to the examples of them, the smallest sizes of the average grain size are, 30 $\mu$m in the patent document 1, 15 $\mu$m in the patent document 2, 15.6 $\mu$m in the patent document 3, 42 $\mu$m in the patent document 4, and 20 $\mu$m in the patent document 5.

Patent Document 1: JP-A-2004-043868
Patent Document 2: JP-A-2004-084065
Patent Document 3: JP-A-2005-036291
Patent Document 4: JP-A-2005-314717
Patent Document 5: JP-A-2005-330549

SUMMARY OF THE INVENTION

Although an Ag-based thin film is applied for a variety of applications as described above, when applied, among them, particularly, to a usage of an ultra-thin film with extremely thin film thickness of approximately 20-200 Å (=2-20 nm) such as a semi-transparent reflective film of the present generation and the next generation optical disks, a low-E film for a heat ray reflective/cutoff window glass, and a shield film for an electromagnetic wave shield, the requirement on in-plane uniformity of the componential composition and a film thickness within the film face becomes more severe. The reason is that, responding to very small variation in the film thickness, the optical properties (thin film properties) such as reflectance and transmittance vary sensitively.

Therefore, provision of an Ag-based thin film extremely superior in in-plane uniformity to the conventional one is earnestly longed to allow applying suitably to the usage of the ultra-thin film as well. As a specific target criterion, superiority in uniformity of the film thickness distribution (in-plane uniformity of the film thickness) is required wherein the film thickness distribution is within the range of $\pm4\text{Å}$ for 200Å of the target film thickness, that is, within $\pm2\%$ range against the target film thickness. However, in all of the sputtering targets described in the patent documents 1-5, the average grain sizes of the targets exceed 15 $\mu$m which cannot satisfy the required properties described above.

The present invention was developed under the consideration of such circumstance and its purpose is to provide an Ag-based sputtering target useful for forming a thin film extremely excellent in in-plane uniformity, and an Ag-based thin film using the Ag-based sputtering target.

In one aspect, the Ag-based sputtering target in accordance with the present invention which could solve the problems is characterized in that, when an average grain size $d_{ave}$ of a sputtering face of the Ag-based sputtering target composed of pure Ag or Ag alloy is measured in accordance with the procedures 1-3 described below, the average grain size $d_{ave}$ is 10 $\mu$m or less.

(Procedure 1) In the surface of the sputtering face, a plurality of locations are optionally selected, and a micrograph of each selected location is taken (magnification: 40-2,000 times).

(Procedure 2) Grain size d (unit: $\mu$m) observed in all micrographs is calculated. First, four or more straight lines are drawn in a grid pattern or radially on each micrograph, and a number n of grain boundaries existing on each straight line is investigated. Then, a grain size d is calculated on the basis of the following equation (1) on each straight line.

$$d=L/n/m \cdots (1)$$

where, L represents the length of the straight line (unit:$\mu$ m),

n represents the number of the grain boundaries existing on the straight line, and

m represents the magnification of the micrograph. (Procedure 3) The average value of the grain sizes d of all selected locations obtained as described above is made the average grain size of the sputtering face $d_{ave}$.

It is preferable that when a value A and a value B described below are calculated on the basis of the following equations (2) and (3) using the grain size d of all selected locations and the average grain size $d_{ave}$ obtained by the procedures 1 to 3, if the larger one of the value A and the value B is made variation of the grain size, the variation of the grain size is 10% or less.

$$\text{Value A} = (d_{max} - d_{ave}) / d_{ave} \times 100 \ (\%) \cdots (2)$$

$$\text{Value B} = (d_{ave} - d_{min}) / d_{ave} \times 100 \ (\%) \cdots (3)$$

where, $d_{max}$ represents the maximum value of the grain size among all selected locations, and

$d_{min}$ represents the minimum value of the grain size among all selected locations.

It is preferable that the Ag alloy contains at least one kind of element selected from a group consisting of Nd, Bi, Au, and Cu.

In the aspect of the present invention, the Ag-based thin film obtained using the Ag-based sputtering target described in either of above is also included.

It is preferable that the film thickness of the Ag-based thin film is 2-20 nm.

According to the aspect of the present invention, an Ag-based sputtering target can be obtained wherein the average grain size existing within the sputtering face is very small as 10 $\mu$m or less and, preferably, the variation of the grain size is also very small.

If the Ag-based sputtering target in accordance with the aspect of the present invention is used, an Ag-based thin film with extremely uniform film thickness (and also componential composition, in the case of Ag alloy) in the film plane direction can be formed. Accordingly, the Ag-based sputtering target in accordance with the present invention is particularly suitably used for forming the Ag-based thin film used for the usage of the technical field, particularly, of very thin film thickness of approximately 20-200Å (=2-20 nm), for example, a semi-transparent reflective film of the present generation and next generation optical disks, a low-E film for a heat ray reflective/cutoff window glass, and a shield film for an electromagnetic wave shield.

BRIEF DESCRIPTION OF THE DRAWINGS

FIG. 1 is a schematic view showing a method for drawing straight lines (in a grid pattern) for measuring the grain size of an Ag-based sputtering target;
FIG. 2 is a schematic view showing a method for drawing straight lines (radially) for measuring the grain size of an Ag-based sputtering target;
FIG. 3 is an explanatory drawing showing the locations A, B, C, D, E for measuring the film thickness of the Ag-based thin film in the example;
FIG. 4 is a sectional drawing partially showing an example of equipment used for manufacturing an Ag-based preform; and
FIG. 5 is a required part enlarged view of X in FIG. 4.

DESCRIPTION OF THE PREFERRED EMBODIMENTS

The present inventor had made investigations to provide an Ag-based sputtering target with the average grain size of the sputtering face being extremely refined fully suitable to the usage of very thin film thickness as well. As a result, the present invention was accomplished after finding that (a) in manufacturing the Ag-based sputtering target, if the spray forming method (SF method) which have not been conventionally adopted is adopted instead of adopting the melting and casting method as represented in the patent documents 1-5, and further, if the SF method is appropriately controlled so that the desired Ag-based sputtering target can be obtained, the average grain size of the target can be extremely refined, and the variation of the grain size also can preferably be lowered further, and that (b) if Ag-based sputtering target in accordance with the present invention is used, in-plane uniformity of the film thickness of the Ag-based thin film is remarkably improved and the target criterion described previously, that is, 200Å $\pm$ 4Å of the target film thickness ($\pm$2% against the target film thickness) can be achieved.

In the present invention, Ag-based sputtering target means the target of pure Ag or Ag alloy. As the Ag alloy used in the present invention, the alloy with Nd, Bi, Au, or Cu as exemplarily described in the examples below can be cited. These elements may either be contained solely or also may be used jointly by two or more kinds. The total amount of these alloy elements is preferably approximately 0.05 atom% or more and 10 atom% or less, more preferably 0.1 atom% or more and 8 atom% or less.

Also, in the present invention, "Ag-based thin film is excellent in in-plane uniformity" means that the film thickness (and the componential composition, in the case of Ag alloy) is uniform in the film plane direction. In other words, it means that the film thickness distribution is uniform within the film face, and in the case of Ag alloy, the componential composition is also uniform. Specifically, those satisfying 200Å $\pm$ 4Å ($\pm$2% against the target film thickness) when the film thickness is measured in the method shown in the example described later is evaluated as "excellent in in-plane uniformity".

Below, the Ag-based sputtering target in accordance with the present invention will be described in detail.

As described above, the average grain size $d_{ave}$ of the sputtering face of the Ag-based sputtering target in accordance with the present invention is characterized in being 10 $\mu$m or less. Therefore, ejection of atoms of Ag and alloy elements which are subjected to sputtering by Ar ion of the sputtering gas becomes uniform and the film thickness of the Ag-based thin film formed on the substrate is made uniform within the face. Because the smaller average grain size $d_{ave}$ is desirable, the uniformity of the distribution of the film thickness and the componential composition in the thin film (in-plane uniformity) can be improved further. Specifically, the average grain size $d_{ave}$ preferably is, for example, 8 $\mu$m or less, more preferably 6 $\mu$m or less.

In the present invention, the average grain size $d_{ave}$ is measured by the procedures 1-3 below.

(Procedure 1)

First, a sputtering face to be measured is prepared. Here, if necessary, the Ag-based sputtering target may be cut in a plane parallel to the sputtering face and the sputtering face to be measured may be exposed to facilitate measuring of the average grain size $d_{ave}$. A cut face in the vicinity of the target surface, preferably, of the outermost surface of the target, is made the object of measuring. However, according to the manufacturing method of the present invention (the detail of which will be described later), it was confirmed in the experiment that the grain size of the target is arranged uniform not only in the direction of the plate face (the flat face of the target) but also in the plate thickness (thickness of the target) direction, therefore, the sputtering face in any thickness of the target can be made the object of measuring.

The grain size included within the face of the sputtering face described above is observed by a microscope.

The microscope observation is performed by, for example, an optical microscope, a scanning electron microscope (SEM), or a scanning ion microscope (SIM). In measuring the crystal grain by optical microscopy observation or scanning electron microscopy observation, it is preferable to perform appropriate etching on the target face to obtain a clear crystal grain. On the other hand, in measuring the crystal grain by scanning ion microscopy observation, etching is not generally performed, but if necessary, etching may be performed.

With respect to the selected locations of the sputtering face, a plurality of locations can be optionally selected, however, the more the locations are selected, the more accurate the average grain size can be obtained. In the present invention, for example, approximately 5-9 locations per 10,000 mm$^2$ of the sputtering face are preferably selected.

Next, a micrograph for each of a plurality of selected locations is taken. The magnification of the microscopy observation can be set optionally according to the grain size. The optimum magnification will be described later, but the magnification is generally set to approximately 40-2,000 times. Also, with respect to microscopy observation, any of optical microscopy observation, scanning electron microscopy observation, or scanning ion microscopy observation may be used as described above. Further, in taking a photo by an optical microscope, processing of polarization or the like may be performed in observing and photo taking for the purpose of obtaining a clear crystal grain.

(Procedure 2)

The micrograph is taken for all selected locations as described above, and the grain size d (unit: $\mu$m) observed in each micrograph is calculated.

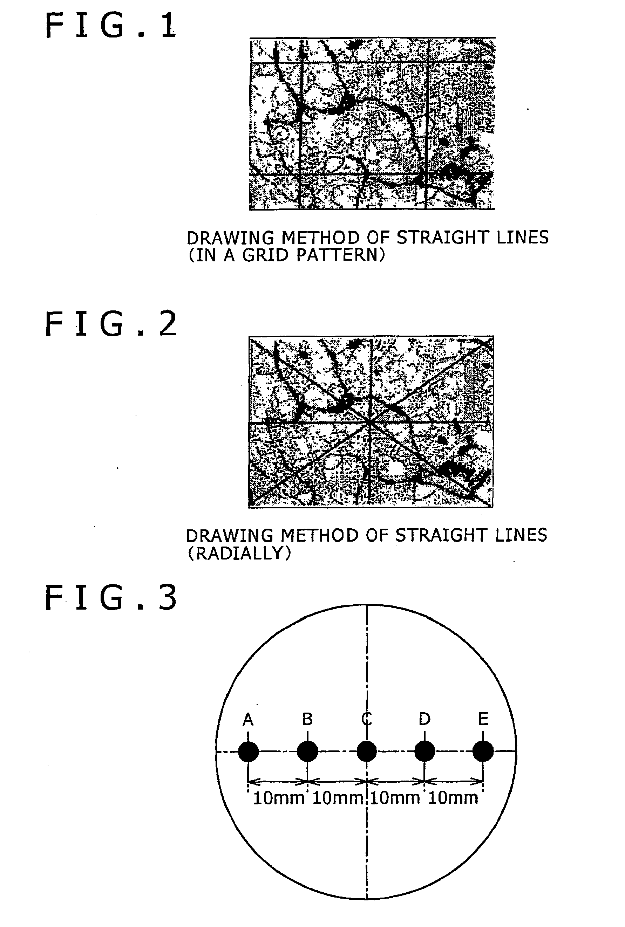

Specifically, first, in each micrograph, four or more straight lines are drawn in a grid pattern (refer to FIG. 1) or radially (refer to FIG. 2) from the end to end of each micrograph, and a number n of grain boundaries on each straight line is investigated. The method of drawing the straight lines may be either in a grid pattern or radially. Also, because the average grain size can be calculated more accurately with more number of straight lines, more number of the straight lines is desirable.

Then, on each straight line, a grain size d is calculated on the basis of the following equation (1).

$$d=L/n/m \cdots (1)$$

where, L represents the length of the straight line (unit: $\mu$m), n represents the number of the grain boundaries existing on the straight line, and m represents the magnification of the micrograph.

Further, the optimum magnification of the microscope must satisfy the following condition. That is, when straight lines are drawn in micrograph as the procedure 2 above and a number n of grain boundaries on each straight line is investigated, setting the magnification of the microscope so that the number n of the crystal boundaries per the length L=100 mm of the straight line becomes approximately 20 is most suited. For example, if the average grain size $d_{ave}$ is approximately 10 $\mu$m, optimum magnification of the microscope is approximately 200-800 times, if the average grain size $d_{ave}$ is approximately 20 $\mu$m, optimum magnification of the microscope is approximately 100-500 times, and if the average grain size $d_{ave}$ is approximately 100 $\mu$m, optimum magnification of the microscope is approximately 50-100 times. If the average grain size $d_{ave}$ exceeds approximately 100 $\mu$m, magnification of the microscope can be approximately 50 times.

(Procedure 3) The grain sizes d of all selected locations are calculated as described above, and the average value of them is made the average grain size of the sputtering face $d_{ave}$.

Further, in the present invention, when the value A and the value B described below are calculated on the basis of the following equations (2) and (3) using the grain size d of all selected locations and the average grain size $d_{ave}$ obtained by the procedures 1-3, if the larger one between the value A and the value B is made variation of the grain size, it is preferable that the variation of the grain size is 10% or less.

$$\text{Value A} = (d_{max} - d_{ave})/d_{ave} \times 100 \ (\%) \cdots (2)$$

$$\text{Value B} = (d_{ave} - d_{min})/d_{ave} \times 100 \ (\%) \cdots (3)$$

where, $d_{max}$ represents the maximum value of the grain size d among all selected locations, and

$d_{min}$ represents the minimum value of the grain size d among all selected locations.

By inhibiting the variation of the grain size to 10% or less as above, ejection of the atoms of Ag and the alloy elements which are subjected to sputtering is made uniform and the film thickness distribution within the film face of the Ag-based thin film becomes uniform further more. The less the variation of the grain size, the better, therefore, uniformity of the distribution of the film thickness and the componential composition in the thin film (in-plane uniformity) can be further improved. Specifically, the variation of the grain size is, for example, preferably 8% or less, more preferably 6% or less.

The thickness of the Ag-based sputtering target in accordance with the present invention is not specifically limited, but is, for example, approximately 1-50 mm, commonly approximately 5-40mm.

Also, the shape of the Ag-based sputtering target is not limited in particular and it can be shaped into a variety of known shapes, but disk-shape is most preferable. In the sputtering target of such disk-shape, the grain size is made uniform in the disk face (sputtering face) direction. If the grain size is uniform in the disk face direction, the distribution of ejection of Ag (and alloy elements, in the case of Ag alloy) which is subjected to sputtering becomes uniform, thereby the uniformity in the film plane direction of the film thickness (and the componential composition, in the case of Ag alloy) of the Ag-based thin film formed on the substrate becomes excellent. Furthermore, if the manufacturing method in accordance with the present invention is used, the grain size in the plate thickness direction also becomes uniform, therefore the Ag-based thin film excellent in the uniformity in the film plane direction of the film thickness (and the componential composition, in the case of Ag alloy) can be stably formed continually from the start to the end of usage of the Ag-based sputtering target.

Next, the manufacturing method of the Ag-based sputtering target in accordance with the present invention will be described.

As was described previously, the manufacturing method in accordance with the present invention is characterized in adoption of SF method which was not adopted so far in manufacturing an Ag-based sputtering target, therefore the target whose average grain size is extremely refined than before can be obtained.

Here, SF method will be described.
SF method is a method for atomizing a variety of molten metal by gas, and depositing the particles cooled quickly into a molten state, a semi-solidified state, or a solidified state, thereby obtaining elemental shape material (an intermediate body before obtaining a final dense body, hereafter referred to as "pre-form") of a prescribed shape. According to this method, there are such merits like, a large pre-form which is hard to obtain by a melting and casting method and a powder sintering method and the like can be obtained by a single process. Also, according to the SF method, the crystal grain can be refined and its uniformity can be remarkably improved as well.

So far, many examples have been disclosed wherein Al-based alloy sputtering targets were manufactured by SF method (for example, JP-A-1997-248665, JP-A-1999-315373, JP-A-2005-082855, and JP-A-2000-225412). However, manufacturing of an Ag-based sputtering target by SF method has never been tried until now. The reason is that in the case of an A1-based sputtering target, fine molten particles (splash) were generated in sputtering and it was necessary to prevent generation of splash by SF method, whereas in the case of an Ag-based sputtering target, there was no such problem in particular and manufacturing by a conventional melting and casting method created no particular inconvenience.

However, in providing an Ag-based thin film preferably applicable, in particular, to the usage of an ultra-thin film with extremely thin film thickness of approximately 2-20 nm, even if the Ag-based target was manufactured, for example, by a conventional melting and casting method as described in the patent documents 1-5 previously described, the Ag-based thin film with extremely excellent in-plane uniformity desired could not be obtained and the target criteria could not be attained (refer to the example described below). On the other hand, if SF method was adopted instead of the conventional melting and casting method, and further, if the SF method preferably modified for manufacturing an Ag-based target was adopted, the average grain size of the Ag-based target was decreased to a degree which had not been attained as stipulated in the present invention, and preferably, it became possible to provide the Ag-based target with the variation of the grain size being controlled extremely small (refer to the example described below).

The manufacturing method of the Ag-based target in accordance with the present invention is roughly categorized to; a process for obtaining an Ag-based pre-form by SF method, a process for densifying the Ag-based pre-form by desification measures such as a hot isostatic press (HIP), a process for performing plastic working of forging or rolling on the Ag-based dense body obtained, and a process for manufacturing the Ag-based target by machining work to form to a prescribed shape.

In this regard, the points particularly effective for refining the grain size of the target and inhibiting the variation of the grain size are, melting temperature of pure Ag or Ag alloy in preparing Ag-based molten metal, a nozzle diameter, a gas kind for atomizing; gas pressure for atomizing, and a gas/metal ratio (=gas flow out rate $[Nm^3]$/molten metal flow out rate [kg]). Specifically, as will be described in detail below, it is preferable to make, melting temperature of pure Ag or Ag alloy to approximately 1,050-1,100 DEG C., the nozzle diameter to approximately 5.0-5.5 mm, the gas kind for atomizing to nitrogen ($N_2$) gas; the gas pressure for atomizing to approximately 6.0-9.0 kgf/cm$^2$, and the gas/metal ratio to approximately 0.4 Nm$^3$/kg or more.

(Manufacturing of the Ag-based alloy pre-form)

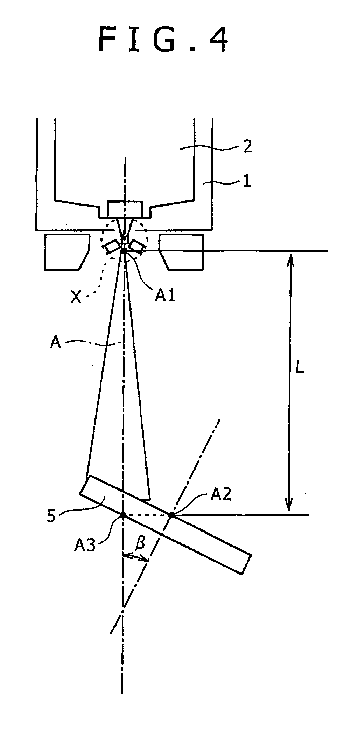

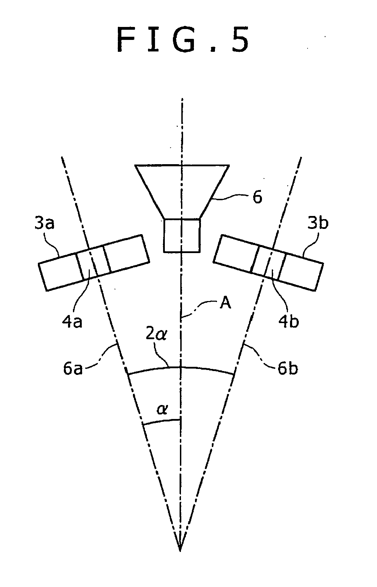

The manufacturing process of a pure Ag or Ag alloy pre-form will be described in detail referring to FIG. 4 and FIG. 5. FIG. 4 is a sectional drawing partially showing an example of equipment used for manufacturing a pre-form used for the present invention. FIG. 5 is a required part enlarged view of X in FIG. 4.

The equipment shown in FIG. 4 includes an induction melting furnace 1 for melting pure Ag or Ag alloy, gas atomizers 3a, 3b disposed below the induction melting furnace 1, and a collector 5 for depositing the pre-form. The induction melting furnace 1 includes a nozzle 6 for making the molten metal 2 of the pure Ag or Ag alloy drop. Also, the gas atomizers 3a, 3b respectively include gas holes 4a, 4b shaped like bobbins for atomizing the gas. The collector 5 includes a driving means (not shown) such as a stepping motor to allow the collector 5 to descend so that the height of the deposit face of the pre-form remains constant even when production of the pre-form proceeds.

In FIG. 5, an example wherein the gas holes 4a, 4b of the bobbins are arranged by one each for respective gas atomizer 3a, 3b is shown but not limited to this. In general, hole of the bobbin is arranged in a plural number according to the gas amount desired.

First, after pure Ag or Ag alloy is put into the induction melting furnace 1, the pure Ag or Ag alloy is molten preferably in vacuum, in an inert gas atmosphere, or in a nitrogen gas atmosphere thereby the molten metal 2 of the pure Ag or Ag alloy is obtained (process for preparation of molten metal of an Ag-based alloy).

In the above process, it is preferable, in particular, to control the melting temperature of the pure Ag or Ag alloy to the range of approximately 1,050-1,100 DEG C. The reason is that the melting temperature of the pure Ag or Ag alloy is one of the factors largely affecting the temperature and size of the particulates (droplets) obtained by gas atomizing, which affects refining of the structure of a dense body eventually.

In this connection, if the melting temperature of pure Ag or Ag alloy is below 1,050 DEG C., the molten metal 2 is solidified in passing through the nozzle and the nozzle may possibly be choked. Whereas, if the melting temperature of pure Ag or Ag alloy exceeds 1,100 DEG C., the structure of the dense body obtained from the pre-form is coarsened and the yield lowers. In addition to the above, under comprehensive consideration of oxidization of the molten metal, lifetime of refractories, energy loss, and the like, the melting temperature of the pure Ag or Ag alloy preferably is within the range of approximately 1,065-1,085 DEG C.

As described above, it is preferable to melt pure Ag or Ag alloy in vacuum, in an inert gas atmosphere or in a nitrogen gas atmosphere, thereby mixture of impurities into the molten metal of the pure Ag or Ag alloy is inhibited. With regard to the inert gas, argon gas or the like, for example, can be cited.

Next, the molten metal 2 of the pure Ag or an Ag alloy obtained as described above is made fall in a chamber (not shown) with a nitrogen gas or inert gas atmosphere through the nozzle 6 (process of gas atomizing). In the chamber, a gas jet flow of high pressure is blown to the molten metal 2 of the pure Ag or Ag alloy from the gas holes 4a, 4b of the bobbins arranged in the gas atomizers 3a, 3b, thereby the molten metal of the pure Ag or Ag alloy is atomized.

It is preferable to perform gas atomizing using nitrogen gas or inert gas as described above thereby mixture of impurities into the molten metal is inhibited. With regard to the inert gas, argon gas or the like, for example, can be cited.

It is also preferable to control the nozzle diameter to approximately 5.0-5.5 mm and the gas pressure of atomizing to approximately 6.0-9.0 kgf/cm$^2$ ranges.

Further, with respect to the gas/metal ratio, it is preferable, for making cooling rate high, to make it approximately 0.4 Nm$^3$/kg or more, more preferably 0.5 Nm$^3$/kg or more. The gas/metal ratio is represented by a ratio of gas flow out amount/molten metal flow out amount. In the specification of the present invention, gas flow out amount means the total amount of the gas which is flown out from the gas holes 4a, 4b of the bobbins for gas atomizing of the molten metal of the pure Ag or Ag alloy (total amount used eventually). In the specification of the present invention, molten metal flow out amount means the total amount of the molten metal which is flown out from a molten metal flow out port (nozzle 6) of a container (induction melting furnace 1) containing the molten metal of the pure Ag or Ag alloy (the total amount flown out eventually).

The gas/metal ratio can be appropriately adjusted according to a nozzle diameter, gas pressure of atomizing, and kind of atomizer (specifically, total area of the holes injecting gas).

Similar to the melting temperature of the pure Ag or Ag alloy described previously, the nozzle diameter, the gas kind and gas pressure of gas atomizing and the gas/metal ratio also are one of the factors affecting the size of the droplets and they affect largely the cooling rate of the droplets. For example, if the gas/metal ratio is controlled to 0.4 Nm$^3$/kg or more, variation of droplets size becomes small and gets close to a constant value. On the other hand, if the gas/metal ratio is below 0.4 Nm$^3$/kg, the droplets size becomes large and the yield of the pre-form lowers.

From the viewpoint described above, the bigger the gas/metal ratio, the better, and it is more preferable to make it, for example, 0.5 Nm$^3$/kg or more as described above. The upper limit is not particularly limited.

Then, the particulates (droplets) of the pure Ag or Ag alloy atomized as described above are deposited in the collector 5 and the pre-form is obtained. The shape of the pre-form, for example, is cylindrical.

(Manufacturing of the Ag-based alloy dense body)

Next, by performing densification measures on the pre-form, the Ag-based dense body is obtained. The reason the dense body is obtained is that the pre-form obtained as above is porous.

The densification measures mean measures for improving the density of the pre-form (50-65% average equivalent density). Here, performing a method for pressing the pre-form generally isostatically, particularly the HIP for hot pressing is preferable. Specifically, performing the HIP processing at 400-600 DEG C. temperature under 80 MPa or more pressure is preferable, thereby the desired dense body can be obtained with a high yield of 85% or more. The reason is that the deformation of the dense body can be minimized and the weight loss occurred during machining the deformed part is minimized by performing the HIP processing under the conditions described above.

If the temperature of the HIP processing is below 400 DEG C. and the pressure of the HIP processing is below 80 MPa, the density of the dense body cannot be raised enough and defects and the like becomes to occur inside. On the other hand, if the temperature of the HIP processing exceeds 600 DEG C., the structure of the dense body is coarsened. Therefore, the HIP processing is performed preferably under 100 MPa or more pressure and at 500-550 DEG C. temperature. The duration of the HIP processing generally is preferably within the range of 1-10 hours.

(Manufacturing of the sputtering target)

Next, an Ag-based sputtering target is obtained using the Ag-based dense body described above.

The manufacturing condition of the sputtering target is not particularly limited and general methods can be adopted. An Ag-based sputtering target can be obtained by, for example, a method wherein, after performing plastic working of forging and/or rolling such as performing of rolling after forging the dense body and obtaining a slab, heat treatment is performed for removing the strain during the plastic working, and further performing machining work to a prescribed shape.

In the above example, plastic working of the dense body performed after the HIP processing is not an essential process, and machining work may be performed instead of plastic working. In such case of no plastic working, the heat treatment for removing strain described above is not necessary. As an example of such manufacturing method, such method can be exemplarily cited wherein the diameter of the dense body is controlled to generally +10 to +30 mm with respect to the diameter of the sputtering target and the dense body after the HIP processing is directly subjected to machining work to a prescribed shape of the sputtering target.

Further, although the heat treatment after the plastic working is to be performed for removing the strain occurred during the plastic working as described above, it is preferable to perform at a lower temperature than the conventional heat treatment temperature (generally 500-600 DEG C., preferably 520-580 DEG C.). The reason is that, if the heat treatment temperature is too high, the grain size may possibly become coarsened, whereas if the heat treatment temperature is too low, the strain remains and deformation may possibly occur during machining work. Therefore, the heat treatment temperature is preferably approximately 450-550 DEG C., more preferably approximately 470-530 DEG C.

With respect to the manufacturing process of the sputtering target described above, it is preferable to select, specifically, an appropriate manufacturing method according to the shape of the sputtering target. For example, if the shape of the sputtering target is disk-shape and its diameter is as small as, for example, 180 mm or less, it is preferable to make the diameter match by performing forging after the HIP processing from the viewpoint of yield.

On the other hand, in the case of the plate-shape sputtering target, it is preferable to perform rolling work to a size near to the prescribed shape of the sputtering target after angularly forging, and to perform machining work finally.

Further, in the manufacturing process of the sputtering target, adoption of ECAP (Equal-Channel Angular Pressing) method is also effective. The ECAP method is a method wherein strong shearing work is applied to material by extruding with the angle of the material being changed while the cross-sectional area being kept unchanged, thereafter it is recrystallized. If the ECAP method is adopted, big strain can be given without changing the size of the material, therefore ultra-refining of the grain size can be realized easily. Consequently, the ECAP method can be suitably used for manufacturing the Ag-based sputtering target wherein the average grain size is extremely refined as in the case of the present invention. Although the ECAP method has been adopted for manufacturing an Al-based sputtering target, there has not been an actual example of application to manufacturing an Ag-based sputtering target as the present invention until now.

The ECAP method can be performed in necessity, for example, after performing the HIP processing as described above.

The sputtering target obtained as above is used, for example, bonded to a backing plate using a brazing material.

The Ag-based sputtering target in accordance with the present invention can be applied to any of sputtering methods of, for example, DC sputtering method, RF sputtering method, magnetron sputtering method, and reactive sputtering method, or the like, and is effective in forming the Ag-based thin film of approximately 2-500 nm thickness.

EXAMPLE

Although the present invention will be described below further specifically by referring to the examples, the present invention intrinsically is by no means to be limited by the examples below and can of course be implemented with appropriate modifications added within the scope adaptable to the purposes described above and below, and any of them is to be included within the technical range of the present invention.

(1) Manufacturing of the sputtering target

On the basis of the manufacturing condition in accordance with the present invention, Ag alloy sputtering targets (examples of the present invention) of the sample Nos. 1-5 shown in Table 2 were manufactured. Specifically, the Ag alloy sputtering targets of the examples of the present invention were manufactured by; using Ag alloys (name: a-f) of a variety of kinds of composition shown in Table 1, and performing the SF process and the HIP process as shown in Table 2 and the plastic working process (working temperature of the plastic working shows the temperature at the start of working) and the heat treatment process as shown Table 3, thereafter performing the machining work. Among them, the sample No. 5 is an example wherein the plastic working of forging → rolling was performed. The shape of the sputtering target sample Nos. 1-5 thus obtained was disk-shape with 101.6 mm diameter and 5 mm thickness.

Also, on the basis of the conventional manufacturing method, Ag alloy sputtering targets (examples of the reference) of the sample Nos. 6, 7 shown in Table 4 were manufactured for comparison purpose. Specifically, the Ag alloy sputtering targets of the examples of the reference were manufactured by; using Ag alloys (name: a, f) of the composition shown in Table 1, performing a melting and casting process, a hot plastic working process (working temperature of the rolling or forging, and the hot plastic working shows the temperature at the start of working), a cold plastic working process (rolling), and a heat treatment process as shown in Table 4, thereafter performing machining work. The shape of the sputtering target sample Nos. 6-7 thus obtained was disk-shape with 101.6 mm diameter and 5 mm thickness.

(2) Evaluation of the sputtering target

Next, the average grain size and the variation of the grain size of the Ag alloy sputtering target of the examples of the present invention (sample Nos. 1-5) and the Ag alloy sputtering target of the examples of the reference (sample Nos. 6, 7) obtained as above were measured on the basis of the method described above. Specifically, an optical microscope photograph (magnification: 1,000 times) was used, 4 straight lines were drawn in a grid pattern, and the grain size d was measured.

The results of them are exhibited in Table 5. In table 5, the kind of an alloy (name of Table 1) used for each sample No. is also shown for ready reference.

(3) Formation and evaluation of the Ag alloy thin film

Then, using the Ag alloy sputtering target of the examples of the present invention and the examples of the reference, Ag alloy thin films (200 Å target film thickness) were respectively film-formed on the glass substrates (disk-shape, 50.8 mm diameter, 0.7 mm thickness) by the DC magnetron sputtering method. Here, the conditions of the DC magnetron sputtering were set to; base pressure: $0.27 \times 10^{-3}$ Pa or less, Ar gas pressure: 0.27 Pa, sputtering power: 200 W, distance between the sputtering target and the substrate: 55 mm, and substrate temperature: room temperature.

The film thickness of each Ag alloy thin film thus obtained was measured on respective measuring locations A, B, C, D, E (total 5 locations) shown in Fig 3. Specifically, as shown in FIG. 3, the center on an optional diameter is made a measuring location C, a measuring location on the straight line apart from the measuring location C by 10 mm to the left is made B, a measuring location on the straight line apart from the measuring location B by 10 mm further to the left is made A. Also, a measuring location on the straight line apart from the measuring location C described above by 10 mm to the right is made D, and a measuring location on the straight line apart from the measuring location D by 10 mm further to the right is made E. Then, the film thicknesses of total 5 locations of these A, B, C, D, E were measured by a feeler-type film thickness measuring instrument.

Next, using the film thickness of each measuring location thus obtained, in-plane uniformity of the film thickness of the Ag alloy thin film was evaluated in accordance with the criteria described below.

Superior in in-plane uniformity of the film thickness (○) : Within the range of 200Å ± 4Å for all measuring locations

(Controlled to within the range of ±2% against the target film thickness)

Inferior in in-plane uniformity of the film thickness (×) : Exceeding the range of 200Å ± 4Å for even one location

(Exceeding the range of ±2% against the target film thickness)

Both of these measuring results and evaluation results were put down in Table 5.

Table 1

| Name | Composition (at%) |
|---|---|
| a | Ag-0.4Nd-0.6Cu |
| b | Ag-0.7Nd-0.9Cu |
| c | Ag-1.0Bi |
| d | Ag-0.4Nd-0.6Bi |
| e | Ag-0.5Bi-1.0Au |
| f | Ag-0.8Cu-1.0Au |

Table 2

| Sample No. | Name of Table 1 | SF Process | | | | | HIP Process | | |
|---|---|---|---|---|---|---|---|---|---|
| | | Melting temp. (DEG C.) | Nozzle diameter (mm) | Gas kind of atomizing | Gas pressure of atomizing (kgf/cm$^2$) | Gas/ metal ratio (Nm$^3$/kg) | Temp. (DEG C.) | Pressure (kgf/cm$^2$) | TIME (h) |
| 1 | a | 1050 | 5.5 | N$_2$ gas | 8.0 | 0.95 | 550 | 1000 | 2 |
| 2 | b | 1100 | 5.5 | N$_2$ gas | 6.0 | 0.55 | 600 | 800 | 2 |
| 3 | c | 1050 | 5.5 | N$_2$ gas | 6.0 | 0.45 | 550 | 1000 | 2 |
| 4 | d | 1050 | 5.5 | N$_2$ gas | 8.0 | 0.80 | 550 | 1000 | 2 |
| 5 | e | 1100 | 5.0 | N$_2$ gas | 9.0 | 1.10 | 600 | 800 | 2 |

Table 3

| Sample No. | Plastic working process | | | | | | Heat treatment process | | |
|---|---|---|---|---|---|---|---|---|---|
| | Method | Working temp. (DEG C.) | Size before working (mm) | Size after working (mm) | Reduction ratio (%) | | Atmosphere | Temp. (DEG C.) | time (h) |
| 1 | N.A. | | | | | | N.A | | |
| 2 | Hot forging | 600 | Cylindrical φ350 ×L | Cylindrical φ210 ×L | -- | | Atmospheric air | 500 | 1.5 |
| 3 | Hot forging | 650 | Cylindrical φ300 ×L | Cylindrical φ170 ×L | -- | | Atmospheric air | 500 | 1.5 |
| 4 | Hot forging | 600 | Cylindrical φ300 ×L | Cylindrical φ210 ×L | -- | | Atmospheric air | 530 | 1.0 |
| 5 | Hot forging | 650 | Cylindrical φ300 ×L | Angular 25t×200W×L | -- | | Atmospheric air | 470 | 1.0 |
| | Hot forging | 600 | Angular 25t×200W×L | Angula 12.5t×200W×L | 50 | | | | |

EP 2 067 873 A1

Table 4

| Sample No. | Name of Table 1 | Melting and casting process | | | | | Hot plastic working process | | | | Cold plastic working process | | Heat treatment process | | |
|---|---|---|---|---|---|---|---|---|---|---|---|---|---|---|---|
| | | Atmosphere | Melting temp. (DEG C.) | Mold material | Shape of cast pierce | Method | Working temp. (DEG C.) | Size before working (mm) | Size after working (mm) | Reduction ratio (%) | Method | Reduction ratio (%) | Atmosphere | Temp. (DEG C.) | time (h) |
| 6 | a | Ar | 1200 | Graphite | Slab-like (30mm thickness) | Rolling | 700 | Angular 30tx200Wx L | Angular 15t×200W× L | 50 | Rolling | 40 | Atmospheric air | 550 | 1.0 |
| 7 | f | Ar | 1100 | Graphite | Cylindrical (150mm diameter) | Forging | 650 | Cylindrical φ150× L | Angular 25t×200W ×600L | | Rolling | 50 | Atmospheric air | 550 | 1.5 |

Table 5

| Sample No. | Name of Table 1 | Ag-based alloy sputtering target | | Ag-based alloy thin film | | Judgment |
|---|---|---|---|---|---|---|
| | | Average grain size ($\mu$m) | Grain size variation (%) | Film thickness of Ag-based alloy thin film (Å) Measuring location A, B, C, D, E | In-plane uniformity of film thickness | |
| 1 | a | 6.5 | 7.5 | 201, 204, 200, 202, 200 | Within $\pm$4Å (within $\pm$2%) | ○ |
| 2 | b | 8.5 | 5 | 198, 204, 200, 202, 204 | Within $\pm$4Å (Within $\pm$2%) | ○ |
| 3 | c | 8.0 | 5.5 | 199, 202, 200, 204, 203 | Within $\pm$4Å (Within $\pm$2%) | ○ |
| 4 | d | 6.5 | 6 | 199, 202, 200, 201, 200 | Within $\pm$2Å (Within $\pm$1%) | ○ |
| 5 | e | 6.0 | 8 | 200, 200, 200, 202, 201 | Within $\pm$2Å (Within $\pm$1%) | ○ |
| 6 | a | 50 | 50 | 190, 205, 200, 196, 207 | Within $\pm$10Å (Within $\pm$5%) | × |
| 7 | f | 40 | 30 | 198, 204, 200, 197, 192 | within $\pm$8Å (Within $\pm$4%) | × |

From Table 5, in all of the Ag alloy sputtering target (examples of the present invention) of the sample Nos. 1-5 manufactured under the conditions in accordance with the present invention, the average grain size is extremely refined and the variation of the grain size is also inhibited low, therefore, the Ag alloy thin films obtained using these sputtering targets are excellent in in-plane uniformity of the film thickness.

On the other hand, in both of the Ag alloy sputtering target (examples of the reference) of the sample Nos. 6, 7 manufactured under the conventional conditions, both of the average grain size and the variation of the grain size were out of the range stipulated in the present invention, and the Ag alloy thin films obtained using these sputtering targets were inferior in in-plane uniformity of the film thickness.

**Claims**

1. An Ag-based sputtering target composed of pure Ag or Ag alloy wherein when an average grain size $d_{ave}$ of a sputtering face of the Ag-based sputtering target is measured in accordance with procedures 1-3 described below, the average grain size $d_{ave}$ is 10 $\mu$m or less,

   (Procedure 1) In the surface of the sputtering face, a plurality of locations are optionally selected, and a micrograph of each selected location is taken (magnification: 40-2,000 times),
   (Procedure 2) Grain size d (unit: $\mu$m) observed in all micrographs is calculated. First, four or more straight lines are drawn in a grid pattern or radially on each micrograph, and a number n of grain boundaries existing on each straight line is investigated. Then, a grain size d is calculated on the basis of the following equation (1) on each straight line,

$$d=L/n/m \cdots (1)$$

   where, L represents the length of the straight line (unit: $\mu$m),
   n represents the number of the grain boundaries existing on the straight line, and

m represents the magnification of the micrograph, (Procedure 3) The average value of the grain sizes d of all selected locations obtained as described above is made the average grain size $d_{ave}$ of the sputtering face.

2.  The Ag-based sputtering target as set forth in Claim 1, wherein the Ag alloy comprises at least one kind of element selected from a group consisting of Nd, Bi, Au, and Cu.

3.  An Ag-based thin film obtained using the Ag-based sputtering target as set forth in Claim 1.

4.  The Ag-based thin film as set forth in Claim 3, wherein the film thickness is 2-20 nm.

5.  The Ag-based sputtering target as set forth in Claim 1, wherein, when a value A and a value B described below are calculated on the basis of the following equations (2) and (3) using the grain size d of all selected locations and the average grain size $d_{ave}$ obtained by the procedures 1-3, and if the larger one of the value A and the value B is made variation of the grain size, the variation of the grain size is 10% or less,

$$\text{Value A} = (d_{max} - d_{ave}) \ / \ d_{ave} \times 100 \ (\%) \cdots (2)$$

$$\text{Value B} = (d_{ave} - d_{min}) \ / \ d_{ave} \times 100 \ (\%) \cdots (3)$$

where, $d_{max}$ represents the maximum value of the grain size d among all selected locations, and $d_{min}$ represents the minimum value of the grain size d among all selected locations.

6.  The Ag-based sputtering target as set forth in Claim 5, wherein the Ag alloy comprises at least one kind of element selected from a group consisting of Nd, Bi, Au, and Cu.

7.  An Ag-based thin film obtained using the Ag-based sputtering target as set forth in Claim 5.

8.  The Ag-based thin film as set forth in Claim 7, wherein the film thickness is 2-20 nm.

FIG.1

DRAWING METHOD OF STRAIGHT LINES
(IN A GRID PATTERN)

FIG.2

DRAWING METHOD OF STRAIGHT LINES
(RADIALLY)

FIG.3

# F I G . 4

# FIG.5

Europäisches
Patentamt

European
Patent Office

Office européen
des brevets

# EUROPEAN SEARCH REPORT

Application Number

EP 08 01 8005

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 02/36847 A (HONEYWELL INT INC [US]) 10 May 2002 (2002-05-10) * claims 11,33,57 * | 1-8 | INV. C23C14/34 C23C14/14 |
| X | US 2003/052000 A1 (SEGAL VLADIMIR [US] ET AL) 20 March 2003 (2003-03-20) * claims 8,13,30 * | 1-8 | |
| X,D | EP 1 659 194 A (KOBE STEEL LTD [JP]; KOBELCO RES INST INC [JP]) 24 May 2006 (2006-05-24) * paragraph [0035]; claim 1 * | 1,2,5,6 | |
| X | US 2004/028912 A1 (TAUCHI YUUKI [JP] ET AL) 12 February 2004 (2004-02-12) * paragraph [0044] * | 3,4,7,8 | |
| X | JP 2004 263290 A (KOBE STEEL LTD [JP]) 24 September 2004 (2004-09-24) * paragraph [0041] * | 3,4,7,8 | |
| | | | **TECHNICAL FIELDS SEARCHED (IPC)** C23C |

The present search report has been drawn up for all claims

| Place of search | Date of completion of the search | Examiner |
|---|---|---|
| Munich | 11 March 2009 | Swiatek, Ryszard |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

Application Number

EP 08 01 8005

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION**
**SHEET B**

Application Number

EP 08 01 8005

The Search Division considers that the present European patent application does not comply with the
requirements of unity of invention and relates to several inventions or groups of inventions, namely:

```
    1. claims: 1,2,5,6

                    Ag-based sputtering target
                        ---

    2. claims: 3,4,7,8

                    Ag-based thin film
                        ---
```

**ANNEX TO THE EUROPEAN SEARCH REPORT
ON EUROPEAN PATENT APPLICATION NO.**

EP 08 01 8005

This annex lists the patent family members relating to the patent documents cited in the above-mentioned European search report.
The members are as contained in the European Patent Office EDP file on
The European Patent Office is in no way liable for these particulars which are merely given for the purpose of information.

11-03-2009

| Patent document cited in search report | | Publication date | Patent family member(s) | | Publication date |
|---|---|---|---|---|---|
| WO 0236847 | A | 10-05-2002 | AU | 3135202 A | 15-05-2002 |
| | | | CN | 1484711 A | 24-03-2004 |
| | | | EP | 1337682 A2 | 27-08-2003 |
| | | | JP | 2004513228 T | 30-04-2004 |
| | | | TW | 247819 B | 21-01-2006 |
| | | | US | 2002153071 A1 | 24-10-2002 |
| | | | US | 6946039 B1 | 20-09-2005 |
| US 2003052000 | A1 | 20-03-2003 | NONE | | |
| EP 1659194 | A | 24-05-2006 | CN | 1823179 A | 23-08-2006 |
| | | | JP | 2005036291 A | 10-02-2005 |
| | | | WO | 2005007923 A1 | 27-01-2005 |
| | | | KR | 20060026964 A | 24-03-2006 |
| | | | TW | 263684 B | 11-10-2006 |
| | | | US | 2006169577 A1 | 03-08-2006 |
| US 2004028912 | A1 | 12-02-2004 | CN | 1483852 A | 24-03-2004 |
| | | | DE | 10336228 A1 | 01-04-2004 |
| | | | KR | 20040014362 A | 14-02-2004 |
| | | | KR | 20060021939 A | 08-03-2006 |
| | | | KR | 20080068798 A | 24-07-2008 |
| | | | SG | 103935 A1 | 26-05-2004 |
| | | | US | 2008317993 A1 | 25-12-2008 |
| | | | US | 2006104853 A1 | 18-05-2006 |
| JP 2004263290 | A | 24-09-2004 | JP | 3997177 B2 | 24-10-2007 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004043868 A
- JP 2004084065 A
- JP 2005036291 A
- JP 2005314717 A
- JP 2005330549 A
- JP 9248665 A
- JP 11315373 A
- JP 2005082855 A
- JP 2000225412 A